# EUROPÄISCHE PATENTSCHRIFT

(11) **EP 1 952 540 B1**
(45) Veröffentlichungstag und Bekanntmachung des Hinweises auf die Patenterteilung: **31.10.2012**
(21) Anmeldenummer: 06818083.5
(22) Anmeldetag: 21.11.2006
(51) Int. Cl.: H03M 7/30

(54) **VERFAHREN ZUR KOMPRESSION FÜR EINEN RECHNERARCHITEKTUR-UNABHÄNGIGEN DATENTRANSFER UND/ODER ZUR DEKOMPRESSION EINES DATENSATZES**
COMPRESSION METHOD FOR A DATA TRANSFER THAT IS INDEPENDENT OF COMPUTER ARCHITECTURE AND/OR DECOMPRESSION METHOD FOR A DATA RECORD
PROCEDE DE COMPRESSION POUR UN TRANSFERT DE DONNEES INDEPENDANT D'UNE ARCHITECTURE D'ORDINATEUR ET/OU DE DECOMPRESSION D'UN ENREGISTREMENT

(30) Priorität: 23.11.2005 DE 102005056122
(43) Veröffentlichungstag der Anmeldung: 06.08.2008
(73) Patentinhaber: Universität zu Lübeck, 23538 Lübeck (DE)
(72) Erfinder: WERNER, Christian, 38259 Salzgitter (DE)
(74) Vertreter: Appelt, Christian W.
(86) Internationale Anmeldenummer: PCT/DE2006/002052
(87) Internationale Veröffentlichungsnummer: WO 2007/059746

(56) Entgegenhaltungen:
- V. TOMAN: "Syntactical Compression of XML Data" PROC. INT. CONF. ON ADVANCED INFORMATION SYSTEMS ENGINEERING, [Online] Juni 2004 (2004-06), Seiten 1-12, XP002454586 Gefunden im Internet: URL:http://caise04dc.idi.ntnu.no/CRC_Caise DC/toman.pdf> [gefunden am 2007-07-24]
- G. LEIGHTON, J. DIAMOND, T. MÜLDNER: "A Grammar-based Approach for Compressing XML"[Online] August 2005 (2005-08), XP002454587 Gefunden im Internet: URL:http://cs.acadiau.ca/research/technica lReports/files/tr-2005-004.pdf> [gefunden am 2007-10-11]
- G. LEIGHTON, T. MÜLDNER, J. DIAMOND: "TREECHOP"[Online] August 2005 (2005-08), Seiten 1-27, XP002454588 Gefunden im Internet: URL:http://cs.acadiau.ca/research/technica lReports/files/tr-2005-005.pdf> [gefunden am 2007-10-11]
- CHENEY J: "Compressing XML with multiplexed hierarchical PPM models" DATA COMPRESSION CONFERENCE, PROCEEDINGS. DCC, IEEE COMPUTER SOCIETY PRESS, LOS ALAMITOS, CA, US, 27. März 2001 (2001-03-27), Seiten 163-172, XP002187036
- WEIMIN LI:[Online] 2003, Seiten 1-86, XP002454589 Gefunden im Internet: URL:http://se.uwaterloo.ca/~ddbms/publicat ions/distdb/Weimin.pdf> [gefunden am 2007-10-11]

## Beschreibung

Die Erfindung betrifft ein Verfahren zur Kompression für einen rechnerarchitekturunabhängigen Datentransfer und/oder zur Dekompression eines Datensatzes nach den Merkmalen der unabhängigen Ansprüche, insbesondere zur gleichzeitigen Verarbeitung von Datensätzen, z. B. für Anwendungen in der Datenübertragung. Die Erfindung betrifft auch die Implementierung von Datenkompressionsalgorithmen in digitalen Schaltkreisen, insbesondere in Mikrochips.

Die fortschreitende Vernetzung elektronischer Rechner hat mittlerweile zur Entwicklung plattformunabhängiger Computersprachen geführt, die den Austausch von Informationen zwischen unterschiedlichen Rechner-Architekturen erlauben. Die übertragenen Daten werden erst von lokal installierten Programmen (z.B. Web-Browser) in Maschinenbefehle übersetzt, die für das Endgerät spezifisch und damit ausführbar bzw. interpretierbar sind. Die Unabhängigkeit von der Architektur wird durch die Einhaltung einer definierten Struktur des übertragenen Datenstroms erreicht, wobei dies im Allemeinen aber auch mit einem - etwa gegenüber gerätespezifischen Optimierungen - erhöhten Datenvolumen einhergeht. Offensichtlich besteht daher ein Bedarf an Verfahren zur Kompression und Dekompression solcher übertragenen Datenströme.

Ziel jeder Datenkompressionstechnik ist es, einen Eingabedatensatz so in einen Ausgabedatensatz umzuwandeln, dass der Ausgabedatensatz kürzer als der Eingabedatensatz ist. Dies ermöglicht eine effizientere Speicherung und Übertragung der Daten. Der Informationsgehalt des Eingabedatensatzes muss dabei jedoch im Ausgabedatensatz (wenigstens in wesentlichen Teilen) erhalten bleiben, so dass man im Rahmen eines Dekompressionsvorgangs den Eingabedatensatz aus dem Ausgabedatensatz zurückgewinnen kann.

Es gibt zwei verschiedene Klassen von Datenkompressionsverfahren: Solche, die auf beliebige Eingabedaten anwendbar sind (Entropiecodierung), und solche, die nur auf spezielle Eingabedaten anwendbar sind (Quellencodierung). Verfahren zur Entropiecodierung arbeiten mit einer statistischen Analyse über die Häufigkeiten der Symbole im Eingabedatensatz. Häufige Symbole im Eingabedatensatz werden im Ausgabedatensatz auf kurze Zeichenketten abgebildet und weniger häufige auf längere. Auf diese Weise kann die Gesamtlänge des Eingabedatensatzes reduziert werden. Solche Verfahren arbeiteten immer verlustfrei, d.h. man kann den Eingabedatensatzes aus dem Ausgabedatensatz exakt rekonstruieren.

Verfahren zur Quellencodierung nutzen dagegen spezielle Eigenschaften des Eingabedatensatzes aus. Ist beispielsweise bekannt, dass hierin Schwarzweiß-Digitalbilder gespeichert sind und schwarze Bildpunkte in der Bildmatrix dabei mit 0 und weiße mit 1 codiert werden, so kann man ausnutzen, dass typische Bildmotive flächige Strukturen aufweisen. Für den Eingabedatensatz bedeutet dies, dass mit großer Wahrscheinlichkeit lange, durchgängige Sequenzen von Nullen bzw. Einsen enthalten sein werden. Diese Eigenschaft kann man beim Kompressionsvorgang berücksichtigen und beispielsweise eine Lauflängencodierung einsetzen. Die Symbolfolge 111111111 wird hier als 9,1 (neun mal eins) kodiert. Einige Quellencodierungsverfahren nutzen zusätzlich Strategien zur Entropiecodierung. Sie erreichen in aller Regel bessere Kompressionsraten als reine Entropiecodierungsverfahren.

Es gibt sowohl verlustfreie als auch verlustbehaftete Verfahren zur Quellencodierung. Verlustbehaftete Verfahren erreichen noch bessere Kompressionsraten als verlustfreie und werden immer dann eingesetzt, wenn nur bestimmte Teile der im Eingabedatensatz kodierten Information relevant sind (z.B. die für das menschliche Gehör wahrnehmbaren Frequenzanteile in einem Audio-Datenstrom).

Verfahren zur Entropiecodierung sind bereits sehr umfassend erforscht. Hier haben sich mehrere Verfahren etabliert, deren Kompressionsergebnisse sehr nah am theoretischen Optimum liegen. Hierzu gehören insbesondere die Verfahren von Shannon-Fano, Huffman, Lempel-Ziv und Lempel-Ziv-Welch.

Verfahren zur Quellencodierung sind für einige Anwendungsbereiche ebenfalls bereits sehr gründlich erforscht: Etwa für Audiodaten (beispielsweise MP3-Encoder) oder Bilddaten (JPEG-Encoder) oder Bewegtbilddaten (beispielsweise MPEG-Encoder). Wie eingangs erwähnt, spielen strukturierte oder teilweise strukturierte Datensätze in der Kommunikation zwischen verschiedenen Rechnern eine besondere Rolle. Solche Datensätze sind nach festen Regeln aufgebaut, beispielsweise der folgenden:
Ein Datensatz besteht aus einem 32-Bit-Integer-Temperaturwert, entweder gefolgt von einem Druckwert oder einem Feuchtigkeitswert, ebenfalls als 32-Bit-Integer. Die Codierung erfolgt als ASCII-Text nach folgendem Muster:
   Temperatur : *Wert1 ,* Druck: *Wert2*
   oder
   Temperatur : *Wert1,* Feuchtigkeit: *Wert2*

Dieser Datensatz enthält einerseits feste Strukturierungsinformationen (Temperatur:, Druck:) und andererseits variable, nicht weiter strukturierte Teile (*Wert1, Wert2*). Bei diesem Datensatz handelt es sich also um einen teilweise strukturierten Datensatz. Datensätze ohne variable Teile wären vollständig strukturiert. Eine solche Durchmengung von Strukturierungsinformationen (im Folgenden Strukturbezeichner genannt) und nicht weiter strukturierten Teilen ist in heutigen Datensätzen durchaus typisch.

Im stand der Technik ist nun die Druckschrift WO 01/27754 A2 bekannt, die ein Quellcodier-Verfahren zur Kompression von Programmquellcodes beschreibt, und solche sind eine mögliche Ausprägung für teilweise strukturierte Datensätze. Dieses Verfahren nutzt aber die Struktur aus, die durch die jeweilige Programmiersprache vorgegeben ist, um eine besonders kompakte Repräsentation des Programmquellcodes zu erzeugen. Das dort beschriebene Verfahren arbeitet dabei mit dem Parse-Baum, der beim Parsen von Programmquelltexten im Speicher eines Rechners aufgebaut wird. Ein wesentlicher Nachteil hierbei ist, dass die Größe des Parse-Baums mit der Länge des zu komprimierenden Datensatzes wächst. Dies führt bei langen Dokumenten zu einem großen Bedarf an Hauptspeicher. Weiterhin ist der Anwendungsbereich dieses Verfahrens auf Computerhochsprachen beschränkt.

Das bekannten Übersetzen eines Programms in Maschinensprache führt zwar oft auf eine verkürzte Repräsentation des Quellcodes, kann aber dennoch nicht als geeigneter Kompressor für die hier gestellte Aufgabe angesehen werden. Denn ein Compiler wird grundsätzlich für die Regeln einer vorab definierten Programmiersprache und für eine vorgegebene Rechnerarchitektur erstellt. Ein unter Windows übersetzter Quellcode ist auf einem Unix-Betriebssystem nicht lauffähig und umgekehrt. Von daher ist ein Transfer kompilierter Programme zwischen verschiedenen Architekturen nicht zweckmäßig.

Überdies ist das übersetzte - mithin auf zumindest einer Architektur ausführbare - Programm nicht unbedingt kürzer als der Quellcode, so dass man bei der Kompilierung prinzipiell nicht von einer Kompression des Quellcodes ausgehen kann. Ein Compiler, dessen Aufgabe ja nicht die Kompression ist, ist auch nicht auf das Dekompilieren übersetzter Dateien ausgelegt. Soweit das Dekompilieren heute technisch realisiert wird, erzeugt es gleichwohl nur einen äquivalenten, aber keinen identischen Quellcode (z.B. werden Kommentarzeilen nicht zurück gewonnen).

Schließlich ist auch nicht bekannt, wie sich ein Compiler-Algorithmus z.B. für eine Hochsprache vollständig in eine Hardware-Schaltung umsetzen ließe, so dass ein direktes Verarbeiten des Quellcodes ohne Übersetzung durch den Mikroprozessor des Rechners nicht möglich ist. Gerade wenn es darum geht, eine große Zahl kurzer Quellcodes in die maschinenlesbare Form zu übersetzen (wie bei heutigen Server-Anwendungen üblich), stellt die zur Übersetzung erforderliche Rechenleistung eine Limitierung dar.

Diese Nachteile der Verwendung von Compilern werden dem Fachmann daher kaum nahe legen, die Aufgabe der Erfindung gerade mit einem Compiler lösen zu wollen.

Weitere Publikationen beschäftigen sich mit der Datenbeschreibungssprache XML, die sich in den letzten Jahren als universelles Mittel zur Beschreibung hierarchisch strukturierter Inhalte durchgesetzt hat. Ein XML-Datensatz besitzt zwei Hauptkomponenten: Markup-Strukturen (strukturierte Teile) und Nutzdaten (nicht weiter strukturierte Teile). Die Markup-Strukturen bestehen dabei aus Tags. Das sind Bezeichner in spitzen Klammern, die die hierarchische Struktur des Datensatzes beschreiben. Zu jedem Bezeichner gibt es ein öffnendes Tag der Form <Bezeichner> und ein schließendes Tag der Form </Bezeichner>. Durch die Verschachtelung von einzelnen Tags wird die Struktur eines Datensatzes abgebildet. Zwischen einem öffnenden Tag und dem korrespondierenden schließenden Tag können dabei entweder weitere Tag-Paare, Nutzdaten oder eine Kombination aus beidem enthalten sein. Nutzdaten sind dabei beliebige anwendungsspezifische Zeichenketten. Grundsätzlich sind in XML-Datensätzen beliebige Markup-Strukturen und beliebige Nutzdaten erlaubt, solange sie den in der XML-Spezifikation beschriebenen Syntax-Regeln genügen.

Für einen konkreten Anwendungsfall sind jedoch typischerweise nur bestimmte Kombinationen sinnvoll. Für den oben genannten Anwendungsfall sollen beispielsweise nur die Tag-Bezeichner Messwerte, Temperatur, Druck und Feuchtigkeit in den oben beschriebenen Kombinationen und Reihenfolgen erlaubt sein.

Solche Einschränkungen kann man mit speziellen Grammatikbeschreibungssprachen für XML festlegen (gebräuchlich sind hier die Sprachen DTD und XML-Schema).

Quellencodierungsverfahren speziell für XML lassen sich daher wiederum in zwei Klassen unterteilen: Solche, die auf beliebige XML-Dokumenten anwendbar sind, und solche, die zunächst eine Grammatikbeschreibung einlesen und dann nur auf die XML-Dokumente anwendbar sind, die dieser Grammatikbeschreibung genügen. Letztere erreichen noch bessere Kompressionsergebnisse.

Zur ersten Gruppe gehören xmlppm, XMill, exalt, fast infoset und XMLZip. Letztge-nanntes ist ein kommerzielles Produkt, das allerdings nicht mehr vertrieben wird. Diese Verfahren separieren die Bereiche von Nutzdaten und Markup und wenden dann auf beide Bereiche Entropiecodierungsverfahren an. Weiterhin werden bestimmte XML-Syntaxregeln bei der Kompression ausgenutzt. Insbesondere wird die Eigenschaft ausgenutzt, dass sich jedes XML-Dokument als Baum (zyklenfreier, zusammenhängender, ungerichteter Graph) darstellen lässt. Durch diese Techniken werden im Vergleich zur reinen Entropiecodierungsverfahren deutlich bessere Kompressionsergebnisse erreicht.

Zur zweiten Gruppe gehören WBXML, Millau, bim, Xebu, Xgrind sowie weitere Tabellencodierungstechniken. Neben den aus der ersten Gruppe bekannten Techniken, werden hier aus der Grammatikbeschreibung zusätzlich bestimmte Muster (Tokens) extrahiert, die im zu komprimierenden XML-Dokument vorkommen dürfen. Jedem Token wird dann eine eindeutige, möglichst kurze Zeichenfolge zugeordnet. Diese Zuordnung wird in einer Tabelle gespeichert, die dann als Abkürzungswörterbuch bei der Kompression dient. Da diese Verfahren Informationen aus der Grammatikbeschreibung für den Kompressionsprozess zusätzlich ausnutzen können, arbeiten sie noch effektiver als generische XML-Kompressoren. Diese Verfahren sind ressourcenschonend, denn hier beschränkt sich der Kompressionsprozess im Wesentlichen auf den Vergleich zwischen Zeichenketten in der Abkürzungstabelle und im Eingabedatensatz. Allerdings sind die erreichten Kompressionsraten prinzipbedingt nicht optimal. Es wird lediglich ausgewertet, welche Tokens im Eingabedatensatz auftreten können. Die Information, in welcher Reihenfolge die Tokens auftreten können, bleibt unberücksichtigt.

Zur zweiten Gruppe gehört ebenfalls das in dem Artikel Werner, Christian; Buschmann, Carsten ; Fischer, Stefan: WSDL-Driven SOAP Compression. In: International Journal of Web Services Research 2 (2005), Nr. 1 vorgestellte Verfahren zur XML-Differenzencodierung. Hier wird nicht mit einer Abkürzungstabelle gearbeitet. Stattdessen wird aus der Grammatikbeschreibung eine Menge von Skelettdatensätzen generiert. Diese stellen alle möglichen Varianten von Datensätzen dar, die dieser Grammatikbeschreibung genügen. Im Rahmen des Kompressionsvorgangs wird dann der zu komprimierende Datensatz mit dem am besten passenden Skelettdatensätzen verglichen und lediglich die Abweichungen zu diesem kodiert. Der Differenzencodierungsansatz ist besonders leistungsfähig. Er berücksichtigt auch Informationen über mögliche Reihenfolgen von Eingabemustern. Doch ist der algorithmische Aufwand bei komplexeren Grammatikbeschreibungen sehr hoch, denn der zu komprimierende Datensatz muss mit einer Vielzahl von Skelettdatensätzen verglichen werden. Dieser Ansatz eignet sich daher nur for ausgewählte Anwendungen mit einfachen Grammatikbeschreibungen.

Gegenwärtige Quellencodierungsverfahren zur Kompression von strukturierten oder teilweise strukturierten Daten benötigen entweder viel Rechenleistung und Speicherplatz oder arbeiten nicht besonders effektiv.

Die meisten bekannten Quellcodierungsverfahren zur Kompression von strukturierten Datensätzen (Ausnahmen sind hier WO 01/27754 A2, WBXML und das Verfahren von Millau) setzen weiterhin zwingend voraus, dass die komprimierten Daten zunächst dekomprimiert werden müssen, bevor sie geparsed und verarbeitet werden können. Dies ist in der Praxis oft ein entscheidender Nachteil: Zum einen, weil durch diesen zusätzlichen Verarbeitungsschritt Verzögerungen eintreten. Zum anderen, weil der dekomprimierte Datensatz im Speicher gehalten werden muss, was gerade im Bereich der mobilen Kleinstcomputer mit sehr begrenztem Hauptspeicher einen gravierenden Nachteil darstellt.

Gerade für Kleinstcomputer ist es ohnehin vorteilhaft und wünschenswert, die Kompression und Dekompression übertragener Daten weitestgehend in der Hardware zu realisieren. Dazu lässt sich das Konzept der Automaten aus der theoretischen Informatik nutzen.

Ein solcher Automat (engl.: "state machine") ist eine sehr einfach aufgebaute Funktionsgruppe. Sie besteht im einfachsten Fall aus einem einzigen getakteten Speicherelement (z.B. einem 16-Bit-Register) und kann in diesem Speicherelement zu einem Zeitpunkt einen einzelnen Wert (Zustand) speichern. Neben diesem Speicherelement gibt es in einem solchen Automaten noch einen Regelsatz, der in Abhängigkeit von dem aktuellen Zustand einerseits und von dem von der Eingabe gelesenen Zeichen andererseits festlegt, welcher Zustand im nächsten Taktschritt eingenommen werden soll. Bestimmte Ausprägungen solcher Automaten besitzen zusätzlich einen sog. Kellerspeicher. Man spricht dann von einem Kellerautomaten (engl.: stack machine).

Ein großer Vorteil dabei ist, dass ein Automat - anders als ein Compiler - keinen Mikroprozessor benötigt, um ausgeführt zu werden; er kann allein auf Basis eines getakteten Speicherelements (als Zustandsspeicher) sowie einem ROM- oder RAM-Baustein (für die Zustandsübergangsregeln) realisiert werden.

Weiter wird bei einem solchen-Automaten kein Parse-Baum im Speicher aufgebaut, wie dies ein Compiler tut. Auch ein Assembler-Übersetzer arbeitet nicht nach dem zustandsbasierten Prinzip eines solchen Automaten.

Der wesentliche Vorteil von Automaten ist zweierlei:
- Aufgrund ihrer einfachen Struktur sind Automaten nach bekannten Verfahren in ein Chip-Design umsetzbar.
- Aus weitgehend beliebigen Strukturregeln eines Datensatztyps (konkretes Beispiel XML) lassen sich nach bekannten Verfahren Automaten (insbesondere String-Automaten, welche von Baum-Automaten zu unterscheiden sind) systematisch konzipieren, die den Datensatztyp verarbeiten können.

Wenn nachfolgend vom "Realisieren" eines String-Automaten gesprochen wird, ist in erster Linie die Schaffung einer entsprechenden Hardwareschaltung gemeint. Eine Realisierung in Form von Software kann aber bekanntlich Hardwareschaltungen simulieren.

Weiter sind Baum-Automaten für die Verarbeitung und Validierung von XML Dokumenten bekannt, so aus der US 2003 0154444 A1. Diese Automatenklasse war in den letzten Jahren Gegenstand vieler Forschungsarbeiten zur Verarbeitung von strukturierten Datensätzen.

Datenkompression mittels String-Automaten wurde bereits in dem Artiekl von Vojtech TOMAN: Syntactical Compression of XML Data. Proceedings of the 16th International Conference on Advanced Information Systems Engineering, 7.-11. Juni 2004, Riga, Lettland vorgeschlagen. Bei dem dort beschriebenen Verfahren wird die Grammatikbeschreibung vorab als nicht bekannt angenommen. Zu Beginn der Verarbeitung existieren also keine Informationen über die Struktur des zu verarbeitenden Datensatzes. Während der Verarbeitung "lernt" der Algorithmus über die Struktur, und für jedes im Datensatz gefundene Symbol wird ein separater String-Automat angelegt und bei Bedarf erweitert, der die diesem Symbol nachgeordnete Sttukturinformation beschreibt. Weiterhin wird an den Zustandsübergängen des Automaten markiert, wie häufig einzelne Strukturzweige in einem solchen Automaten abgerufen werden. Bei der Verarbeitung des Eingabedatensatzes greift man auf diese Automaten zurück. Eine kompakte Codierung des Eingabedokuments wird erzeugt, indem man die Häufigkeitsmarkierungen der genutzten Zustandsübergänge auswertet und anhand dieser eine Vorhersage trifft, welches Symbol als nächstes folgt.

Für den praktischen Einsatz ist das Verfahren nur bedingt geeignet, weil bei der Verarbeitung eines Datensatzes dynamisch neue Automatenstrukturen angelegt und aktualisiert werden müssen. Für eine Implementierung als Chip ist dies unvorteilhaft, weil nicht vorab bekannt ist, wie viele Speicherzellen auf dem Schaltkreis vorgesehen werden müssen. Weiterhin ist nachteilig, dass die Automatenstrukturen nie vollständig die Regeln abbilden, denen der Datensatz genügt. Auch bei sehr langen Datensätzen, bei denen der Algorithmus sehr viele Informationen über die Struktur des Datensatzes "lernen" kann, beschreiben die schrittweise erzeugten Automaten die Struktur des Datensatzes nicht zwangsläufig vollständig. Toman konstruiert zudem nur solche String-Automaten, die in der Klasse der azyklischen, deterministischen endlichen Automaten liegen. Diese reichen nur zur Beschreibungen von sehr einfachen Strukturbeschreibungen aus.

Die Aufgabe der Erfindung ist es, ein gegenüber Levene et al. alternatives Verfahren zur Kompression bzw. Dekompression von wenigstens teilweise strukturierten Datensätzen anzugeben. Eine weitere Aufgabe der Erfindung besteht darin, Verfahren zur Kompression bzw. Dekompression von wenigstens teilweise strukturierten Datensätzen anzugeben, die leicht in Hardware zu implementierbar sind.

Diese Aufgaben werden durch den Gegenstand der unabhängigen Patentansprüche gelöst. Die abhängigen Patentansprüche geben vorteilhafte Ausgestaltungen der Erfindung an.

Das Dokument "XML Structure Compression" von Levene und Wood (Proceedings of the 2ND International Workshop on World-Wide-Web, 2002/2003) zeigt eine Kompression von XML Dokumenten, bei der Zunächst ein Parse-Baum für das zu komprimierende Dokument unter Berücksichtigung der DTD erzeugt wird. Dieser Parse-Baum wird dann reduziert (Pruning) und der reduzierte Parse-Baum unter Berücksichtigung von möglichen Knoten-Alternativen und -Wiedermolungen Kodiert. Der im Rahmen der Pruning entfernte Text-Teil des XML-Dokuments wird zusammen mit dem kodierten, reduzierten Parse-Baum übertragen.

Das vorgeschlagene Verfahren zur Kompression und/oder Dekompression eines Datensatzes, der Struktur und Variablenwerte enthält, zeichnet sich aus durch Vorsehen eines die vorab bekannten Struh-turierungsregeln des Datensatzes repräsentierenden String-Automaten in einer den Ursprungs-Datensatz komprimierenden Einrichtung, Eingeben des Datensatzes in den String-Automaten, Erzeugen eines zweiten, kürzeren Datensatzes durch den String-Automaten, der die Variablenwerte des ersten Daterisatzes und String-Automaten-spezifische Steuersymbole enthält, die einen Wechsel von einem Automatenzustand in einen Folgezustand repräsentieren, und Übermitteln des zweiten Datensatzes an einen die Steuersymbole interpretierenden gleichartigen String-Automaten, wobei eine Kopie des ursprünglichen Datensatzes mit gleicher Datenstruktur erzeugt wird.

Der entscheidende Erfindungsgedanke, besteht in der Einführung von Steuersymbolen dort, wo die Zustandsähderungen des Automaten Verzweigungsmöglichkeiten aufweisen. Erst das Ersetzen der ansonsten im unkomprimierten Datensatz mitgeführten Struktursymbole durch die sehr kurzen Steuersymbole des Automaten führen auf die hohe Kompressionseffizienz. Dass dies überhaupt möglich ist, liegt wiederum an den im Automatendesign endgültig festgelegten Strukturregeln der zu verarbeitenden Datensätze.

Natürlich kann auch nur eine Dekompression eines zuvor z.B. über das Internet erhaltenen Datensatzes erfolgen, der Steuerdaten für String-Automaten und Variablenwerte enthält. Dann ist der Datensatzes nur in einen vorgegebenen, bekannten String-Automaten einzugeben, der ihn interpretiert und daraus wieder eine unkomprimierte Repräsentation des Datensatzes erzeugt und/oder externe Funktionsgruppen steuert.

Wesentlich bei der Erfindung ist es, den zu komprimierenden Datensatz so umzucodieren, dass diese komprimierte Darstellung den Durchlauf eines String-Automaten beschreibt. Dieser Durchlauf wird dabei über geeignete Steuersymbole beschrieben, die dabei "Weichenstellungen" repräsentieren.

In anderen Worten: Das vorgeschlagene Kompressionsverfahren besteht darin, einen Weg aufzuzeigen, wie ein einfacher Hardware-Kompressor -der zugleich Dekompressor und Verarbeiter des komprimierten Datensatzes ist - allgemein hergestellt werden kann. Ein solcher Chip kann für jedes - weitgehend beliebige - Kompressionsproblem systematisch entworfen und industriell hergestellt werden. Eingebaut in beliebige Rechnerarchitekturen lässt er dann die völlige Transferfreiheit komprimierter Datensätze zu. Die hierzu nötigen, erfindungsgemäßen Steuersymbole sind in "normalen" Kellerautomaten, wie sie in der Literatur für Standardanwendungen beschrieben werden, nicht vorhanden bzw. werden nicht verarbeitet.

Die Steuersymbole sind prinzipiell durch wenige Bits darstellbar. Mit dem Verfahren lässt sich die Größe typischer Datensätze um Faktoren zwischen 10 bis 15 reduzieren. Diese Einsparung wird vor allem dadurch erreicht, dass die Strukturinformationen in einem Datensatz schon durch eindeutige Zustandsübergänge im bekannten String-Automaten beschrieben ist: Ein Großteil der Zustandsübergänge im String-Automaten besitzt also nur einen Folgezustand. Da in einem solchen Fall der Zustandsübergang schon feststeht, muss diese Information in Ausgabedaten nicht codiert werden. Anders ausgedrückt: Solche eindeutigen Zustandsübergänge können mit 0 bit codiert werden.

Somit kann die gesamte Strukturinformation eines Datensatzes auf wenige Bits reduziert werden. Alle Tags oder Tokens, die Strukturinformationen beschreiben, werden aus dem Datensatz entfernt, da die Datenstruktur bereits im Automaten abgebildet ist. Insbesondere muss auch keine Übersetzungstabelle vorgehalten werden.

Der so komprimierte Datensatz ist nur für den Durchlauf in diesem speziellen Automaten geeignet, er muss also insbesondere dem Empfänger einer komprimierten Übertragung bekannt sein. Er enthält aber lediglich Variablenwerte und die kompakt codierten Steuersymbole, d.h. keinerlei redundante Information. Offensichtlich kann der Datensatz auch ohne vorangehende Dekompression vollständig verarbeitet werden.

Weiterhin sind solche Automaten leicht in Hardware zu realisieren. Im digitalen Schaltkreisentwurf sind Automaten Standardbaugruppen und damit Bestandteil nahezu jeder getakteten Digitalschaltung.

Die Erfindung wird im Folgenden anhand einer Zeichnung genauer erläutert. Dabei zeigen :
- Fig. 1: einen endlichen Automaten, der Eingabedatensätze W mit dem Muster aⁿbbc^{m} akzeptiert,
- Fig. 2: einen endlichen Automaten für die Erkennung von Datensätzen zur Messdatenerfassung, und

- Fig. 3: einen erweiterten endlichen Automaten für die Erkennung von Datensätzen zur Messdatenerfassung und
- Fig. 4: einen Ausgabedatensatz.

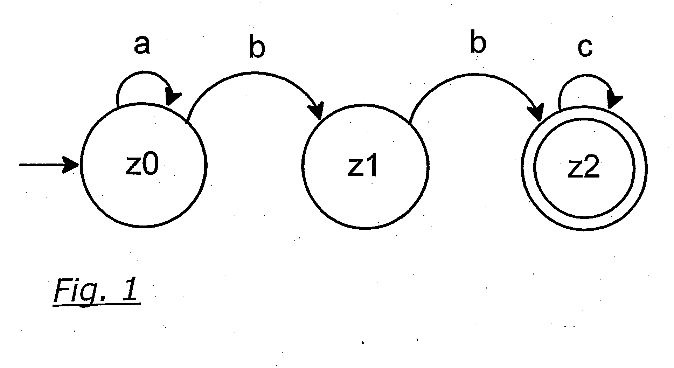

Ein String-Automat ist eine Funktionsgruppe, die die Gültigkeit eines Eingabedatensatzes W anhand von vorgegebenen Zuständen und Zustandsübergängen überprüft. Das Beispiel in Fig. 1 erläutert anschaulich das grundsätzliche Vorgehen. Ein String-Automat besteht aus Zuständen und Zustandsübergängen. In der graphischen Darstellung sind dies die Kreise und Pfeile zwischen den Kreisen. Ein Zustand ist dabei als Startzustand gekennzeichnet (Pfeil zeigend auf z0). Ein oder mehrere Zustände sind als Endzustände gekennzeichnet (Doppelkreise). Die Übergänge zwischen den Zuständen tragen eine Beschriftung in Form einer Zeichenkette, daher auch der Name String-Automat.

Bei der Überprüfung eines Eingabedatensatzes W durchläuft der Automat eine Sequenz von Zuständen. Der Automat verarbeitet W Zeichen für Zeichen von links nach rechts und wählt die Zustandsübergänge mit den passenden Beschriftungen aus. Gibt es keine passenden Zustandsübergänge oder endet die Sequenz in einem Zustand, der nicht Endzustand ist, so ist das Eingabewort nicht gültig; andernfalls ist es gültig.

Für den Eingabedatensatz W1=aabbc würde der dargestellte Automat die Sequenz z0, z0, z0, z1, z2, z2 durchlaufen. Der Zustand z2 ist Endzustand, also ist W1 eine gültige Eingabe.

Der Eingabedatensatz W2=abba wäre dagegen nicht gültig, weil sich hier die Teilsequenz z0, z0, z1, z2 ergibt, und es keinen Übergang von z2 mit der Beschriftung a gibt. Auch W3=aaab wäre nicht gültig, weil die sich ergebene Sequenz z0, z0, z0, z0, z1 nicht mit einem Endzustand endet.

Es gibt mehrere Typen von String-Automaten. Fig. 1 zeigt ein Beispiel für die einfachste Ausprägung : einen Endlichen Automaten. Dieser Typ verfügt über keine weiteren Speicherelemente (außer denen für Zustand und Zustandsübergänge) und kann daher prinzipbedingt nur einfach strukturierte Datensätze verarbeiten (solche, die Wörter einer Sprache sind, welche in der Klasse der Regulären Sprachen liegt).

Neben dem Typus Endlicher Automat ist insbesondere auch der Einsatz von Kellerautomaten gängig. Diese sind wie ein Endlicher Automat aufgebaut, verfügen aber zusätzliche über einen Kellerspeicher (häufig auch als LIFO-Speicher bezeichnet). Die Lese- und Schreiboperationen des Kellerspeichers werden über zwei zusätzliche Beschriftungen jedes Zustandsübergangs gesteuert. Jeder Zustandsübergang trägt also drei Beschriftungsfelder:
- zu lesendes Eingabezeichen,
- zu lesendes Zeichen aus dem Kellerspeicher,
- zu schreibende Zeichen in den Kellerspeicher.

Mit einem Kellerautomaten kann man auch komplexer strukturierte Eingabedatensätze verarbeiten (solche, die Wörter einer Sprache sind, welche in der Klasse der kontextfreien Sprachen liegt, vgl. Schöning, Uwe: Theoretische Informatik kurzgefaßt. 3. Auflage. Spektrum, 1997).

Grundsätzlich eignen sich sämtliche String-Automaten-Typen zur Umsetzung des Verfahrens. Jeder Typ kann in bestimmten Anwendungen jedoch spezifische Vorteile bieten: Endliche Automaten benötigen beispielsweise sehr wenig Speicher und Kellerautomaten sind besonders vielseitig einsetzbar, weil sie alle kontextfreien Sprachen erkennen können.

Das Erzeugen eines String-Automaten aus Strukturbesehreibungen wie etwa Regulären Ausdrücken ist bekannt. Insbesondere lassen sich aus XML-Grammatikbeschreibungen (DTD, XML-Schema-Dokument) Kellerautomaten konstruieren [Segoufin L.; Vianu, V.: Validating Streaming XML Documents. Proceedings of the 21st ACM SIGMOD-SIGACT-SIGART symposium on Principles of database systems, Madison, Wisconsin, USA, 2002].

Das erfindungsgemäße Verfahren fokussiert auf die Anwendung dieser Automaten zur Entfernung redundanter Strukturinformationen aus dem Datensatz und auf die Einführung von Steuersymbolen zur Kontrolle des Automatenablaufes dort, wo alternative Zustandsänderungen möglich sind.

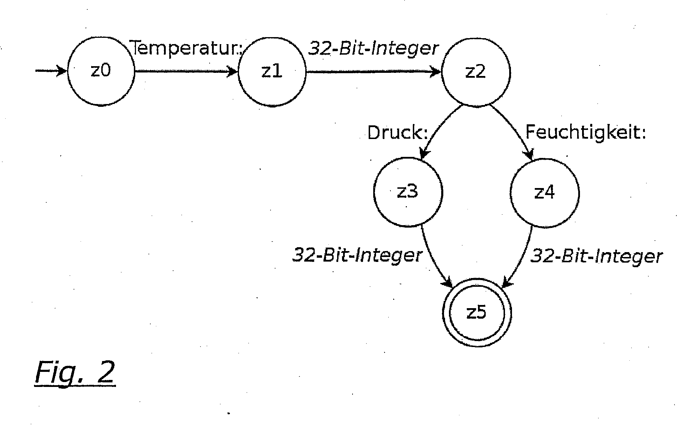

Für das eingangs genannte Beispiel lässt sich ein Endlicher Automat - wie in Fig. 2 dargestellt - angeben, der die Struktur der zu verarbeitenden Eingabedatensätze beschreibt. Die Alternative, ob nach dem Temperaturwert ein Druckwert oder ein Feuchtigkeitswert folgt, ist im Automaten durch zwei mögliche Zustandsübergänge ausgehend von z2 beschrieben.

Die Automatenbeschreibung kann weiterhin Informationen über den Inhalt von nichtstrukturierten Bereichen im Eingabedatensatz enthalten (Boolean, String der Länge 10, 16-Bit-Integer usw.). Im Beispiel ist an den Zustandsübergängen von z3 nach z5 und von z4 nach z5 jeweils angegeben, dass hier numerische Werte erwartet werden, die sich als 32-Bit-Integer-Zahl darstellen lassen. Diese Information wird beim Kompressionsprozess ausgewertet, um besonders kompakte Codierungen für mögliche Werte zu finden. Bei der Dekompression wird diese geänderte Darstellungsweise wieder rückgängig gemacht. Die in einem Datensatz enthaltenen Variablenwerte können sowohl von einem kodierenden als auch von einem interpretierenden String-Automaten bei der Verarbeitung geändert kodiert ausgegeben bzw. erkannt und umgewandelt werden.

Damit der Automat für die Kompression eingesetzt werden kann, muss er zunächst wie folgt erweitert werden:
Besitzt der Automat Zustände mit mehr als einem möglichen Folgezustand, werden die Zustandsübergänge zu den Folgezuständen mit zusätzlichen, lokal eindeutigen Bezeichnem (Steuersymbole) versehen. Es entsteht ein erweiterter String-Automat.

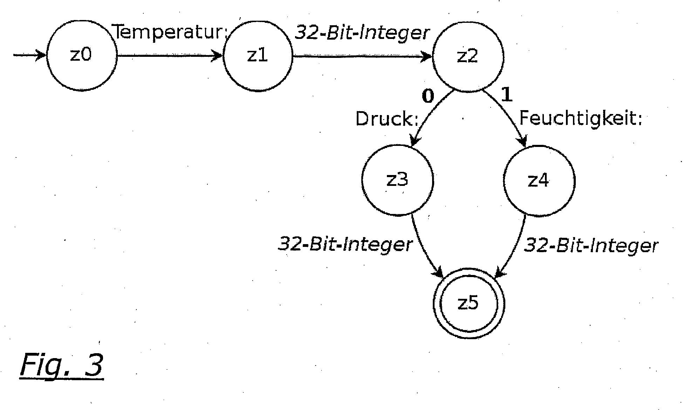

Im Beispiel wäre eine solche Erweiterung also bei z2 notwendig. Es gibt nur zwei Folgezustände, folglich genügt ein einzelnes Bit zur eindeutigen Codierung. Im Beispiel wird der Übergang nach z3 mit 0 und der nach z4 mit 1 markiert. Fig. 3 zeigt ein Beispiel für so einen erweiterten Automaten.

Bei mehr als zwei möglichen Folgezuständen muss die Bitfolge länger werden. Zur Erzeugung von solchen eindeutigen Codes für die Zustandsübergänge eignet sich insbesondere das Codierungsverfahren von Huffman. Es erzeugt minimale, eindeutige Codes und kann auch die Wahrscheinlichkeiten der Zustandsübergänge berücksichtigen. Ist also bekannt, dass bestimmte Zustandsübergänge häufiger als andere gewählt werden, so lassen sich diese mit besonders kurzen Bitfolgen codieren. Dies wirkt sich positiv auf das Kompressionsergebnis aus.

Der erweiterte String-Automat verarbeitet den zu komprimierenden Eingabedatensatz: Werden dabei Zustände mit mehr als einem möglichen Folgezustand durchlaufen, wird der lokal eindeutige Bezeichner des gewählten Zustandsübergangs im Ausgabedatensatz codiert. Werden bei Zustandsübergängen nicht-strukturierte Inhalte von der Eingabe gelesen, so werden diese ebenfalls im Ausgabedatensatz codiert.

### Für den Beispieldatensatz

### Temperatur:121,Druck:918

würden die folgenden Aktionen ausgeführt werden:

| Zustand | lese (aus Eingabedatensatz) | schreibe (in Ausgabedatensatz) |
|---|---|---|
| z0 (Start) | Temperatur: (Strukturbezeichner) | - (Übergang ist eindeutig) |
| z1 | 121 | 121 als 32-Bit-Integer |
| z2 | ,Druck: (Strukturbezeichner) | '0' (Übergang nach z3) |
| z3 | 918 | 918 als 32-Bit-Integer |
| z5 (Ende) | - | - |

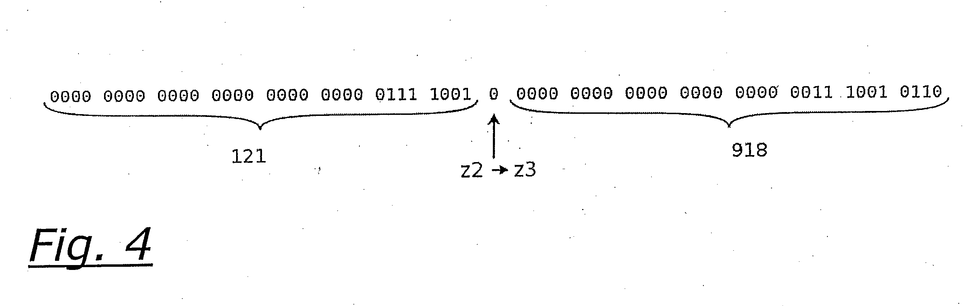

Damit ergibt sich der Ausgabedatensatz wie in Fig. 4.

In diesem Datensatz, der lediglich 65 Bits lang ist, sind sämtliche Informationen codiert, die zur Rekonstruktion des Eingabedatensatzes mit Hilfe des String-Automaten notwendig sind. Die Länge des unkomprimierten Eingabedatensatzes in 7-Bit-ASCII-Codierung beträgt 24x7=168 [Bits].

Ausgangspunkt für den Dekompressionsprozess ist wiederum der zur Kompression verwendete erweiterte String-Automat. Dieser Automat wird abermals vom Start- zu einem Endzustand durchlaufen. Allerdings wird der Automatendurchlauf bei der Dekompression durch den Datensatz gesteuert, der Ergebnis des Kompressionsprozesses ist. Beim Durchlauf werden die Werte, mit denen die Zustandsübergänge beschriftet sind, in den Ausgabedatensatz geschrieben. Die Werte nicht strukturierter Inhalte werden dabei dekodiert und ebenfalls in den Ausgabedatensatz geschrieben.

Für das obige Beispiel ergibt sich:

| Zustand | lese (aus Eingabedatensatz) | schreibe (in Ausgabedatensatz) |
|---|---|---|
| z0 (Start) | - (Übergang ist eindeutig) | Temperatur: (Strukturbezeichner) |
| z1 | 32-Bit-Integer | 121 |
| z2 | '0' (Übergang nach z3) | ,Druck: (Strukturbezeichner) |
| z3 | 32-Bit-Integer | 918 |
| z5 (Ende) | - | - |

Der Beispieldatensatz kann so exakt rekonstruiert werden.

Bei komplexeren String-Automaten, bei denen die Zustandsübergänge nicht nur durch den Eingabedatensatz gesteuert werden, sondern auch von anderen Parametern abhängen (beispielsweise vom obersten Wert im Speicher eines Kellerautomaten), kann es sinnvoll sein, die Erweiterung des String-Automaten nicht vorab, sondern im Rahmen des Kompressions- und Dekompressionsprozesses dynamisch durchzuführen.

Beispiel: Der Zustand z4 in einem Kellerautomaten hat zehn mögliche Folgezustände. Bei einer der statischen Erweiterung des Automaten müssten diese zehn Zustände bei Anwendung eines Block-Codes mit ┌log₂ 1┐ = 4 Bits codiert werden.

Bei der Verarbeitung eines Eingabedatensatzes X erreicht der Automat nun z4. Aufgrund des obersten Eintrags im Kellerspeicher sind jedoch nur zwei der zehn Zustandsübergänge möglich. In dieser Situation müssen auch nur diese zwei Zustände codiert werden, denn nur sie können bei der Verarbeitung der Eingabe ausgewählt werden; hierfür reicht ein Bit aus.

Da sich der Zustand des Kellerspeichers aber dynamisch mit der Verarbeitung des Eingabedatensatzes ändert, lässt sich eine solche optimierte Codierung nur dynamisch, d.h. während der Verarbeitung eines Eingabedatensatzes bestimmen. Dies führt zu besseren Kompressionsergebnissen, hat jedoch auch den Nachteil, dass bei der Kompression und Dekompression zusätzliche Berechnungsschritte durchgeführt werden müssen. Somit ist die Verarbeitungsgeschwindigkeit etwas geringer.

Sowohl der Prozess der Kompression als auch der der Dekompression beruhen im Wesentlichen darauf, dass die Zustände eines String-Automaten durchlaufen werden. Diese sind besonders einfach aufgebaut und können effizient in Hard- oder Software implementiert werden.

Bei einem Endlichen Automaten wird nur ein RAM-Speicherbereich zum Halten des aktuellen Zustands (currentstate) benötigt. Die Zustandsübergänge (transitions) des Automaten können als Tabelle in einem ROM-Bereich abgelegt werden. Startzustand (start_state) und Endzustände (end_states) sind ebenfalls nicht variabel und können daher ebenfalls im ROM abgelegt werden.

Auch ein Kellerautomat ist nur wenig komplexer; dort muss lediglich ein zusätzlicher RAM-Speicherbereich als Kellerspeicher (Stack) bereitgestellt werden.

Ein besonderer Vorteil solcher Automaten liegt somit in ihrer sehr einfachen Implementierbarkeit. Die Implementierung eines String-Automaten beschränkt sich im Wesentlichen auf den Durchlauf einer While-Schleife, und der benötigte Speicherplatz ist sehr gering.

Auch im Chip-Design sind Automatenstrukturen gängige Baugruppen: Die in diesem Zusammenhang eingesetzten Automatenstrukturen werden häufig als Finite-State-Machines oder Moore-Automaten bezeichnet und entsprechen weitestgehend den oben vorgestellten Endlichen Automaten. Für die Implementierung eines Kellerautomaten in Hardware müsste die Automatenstruktur um einen Kellerspeicher (Stack) erweitert werden, der ebenfalls eine Standardbaugruppe ist.

Neben diesen Vorteilen bei der Implementierung bietet das Verfahren auch die Möglichkeit, die Vorgänge des Parsens und der Datenkompression bzw. -dekompression zu einem einzigen Verarbeitungsschritt zusammenzufassen:

Die Steuerung des Automatendurchlaufs kann direkt über eine Programmierschnittstelle (API) aus einer anderen Softwarekomponente erfolgen. Bei einer Hardwareimplementierung könnte der Automatendurchlauf über Steuerleitungen von anderen Bau- oder Funktionsgruppen aus gesteuert werden. Dies hat den Vorteil, dass im Speicher der datenkomprimierenden Einrichtung gar keine unkomprimierte Darstellung der zu komprimierenden Daten vorgehalten werden muss. Diese Darstellungsform ist unter Umständen sehr groß und verbraucht unnötig Speicherkapazität der datenkomprimierenden Einrichtung. Beispielsweise wäre es möglich, auf einer Maschine, die Messdatensätze erzeugt, gar nicht die unkomprimierte Repräsentation des Datensatzes mit Messwerte zu erzeugen. Beim Erfassen der Messwerte wird der. Durchlauf des String-Automaten direkt durch diesen technischen Prozess gesteuert. Das Kompressionsergebnis entspricht aber dem, als hätte eine nicht komprimierte Repräsentation des Datensatzes vorgelegen, so dass ein Empfänger des komprimierten Datensatzes die Messdaten ganz normal dekomprimieren und interpretieren oder weiterverarbeiten kann.

Das oben bezeichnete Verfahren erlaubt zudem, dass der String-Automaten während seines Ablaufs zusätzlich bereits die Steuerung externer Funktionsgruppen veranlasst. Beispielsweise wäre es möglich, dass im Rahmen der Dekompression gar nicht die unkomprimierte Repräsentation des Datensatzes wiederhergestellt werden soll. Möglichweise soll alternativ oder zusätzlich auch eine externe Funktions- oder Baugruppe (beispielsweise eine externe Softwarekomponente, Produktionsanlage oder Recheneinheit) in Abhängigkeit von den aus dem Datensatz gelesenen Werte gesteuert werden. Viele technische Vorgänge lassen sich nämlich direkt auf ein Automatenmodell abbilden, wie es die Erfindung vorschlägt.

## Patentansprüche

1. Verfahren zur Kompression eines Datensatzes, umfassend die Schritte:
Eingeben des Datensatzes in den String-Automaten, einer Kompressionsvorrichtung, wobei der String-Automat die vorab bekannten Strukturierungsregeln des Datensatzes repräsentiert, und wobei der eingegebener Datensatz Strukturbezeichner und Variablenwerte enthält und den vorab bekannten Strukturierungsregeln entspricht,
Verarbeiten des eingegebenen Datensatzes durch den String-Automaten um einen komprimierten Datensatz zu erzeugen, wobei der komprimierte Datensatz den durch die Strukurbezeichner des eingegebenen Datensatzes bedingten Durchlauf des String-Automaten beschreibt indemer neben den Variablenwerten des in den String-Automaten eingegebenen Datensatzes Steuersymbolen enthält, die die Zustandsübergänge des Durchlaufs des String-Automaten repräsentieren.

2. Verfahren nach Anspruch 1, wobei beim Verarbeiten des eingegebenen Datensatze durch den String-Automaten nur Steuersymbole für Automatenzustände, die mehrere mögliche Folgezustände besitzen, in den komprimierten Datensatz eingefügt werden.

3. Verfahren nach Anspruch 1 oder 2, ferner umfassend den Schritt des Übermittelns des komprimierten Datensatzes an eine Dekompressionsvorrichtung.

4. Verfahren nach einem der Ansprüche 1 bis 3, wobei der eingegebene Datensatz ein XML Dokument ist.

5. Verfahren nach einem der Ansprüche 1 bis 4, wobei die Verarbeitung des Datensatzes durch den String-Automaten von externen Funktion- oder Baugruppen gesteuert wird.

6. Verfahren nach einem der Ansprüche 1 bis 5, ferner umfassend den Schritt des Berücksichtigens von Wahrscheinlichkeiten oder Häufigkeiten von Zustandsübergängen, um besonders geeignete Bitrepräsentationen für die zugehörigen Steuersymbole zu finden.

7. Verfahren zur Dekompression eines komprimierten Datensatzes, umfassend die Schritte:
Eingeben des komprimierten Datensatzes in den String-Automaten einer Dekompressionsvorrichtung, wobei der Sring-Automat die vorab bekannten Strukturierungsregeln des zu dekomprimierenden Datensatzes representiert und, wobei der Datensatz Steuersymbole für den String-Automaten und Variablenwerte enthält und den vorab bekannten Strukturierungsregeln entspricht, und
Verarbeiten des eingegebenen, komprimierten Datensatzes durch den String-Automaten um einen dekomprimierten Datensatz zu erzeugen, wobei der String-Automat die Steuersymbole durch Strukturbezeichner ersetzt, um dadurch den dekomprimierten Datensatz mit den Strukturbezeichnern und den Variablenwerten zu erzeugen.

8. Verfahren nach Anspruch 7, wobei der String-Automat während des Verarbeitens des komprimierten Datensatzes zusätzlich oder alternativ zur Ausgabe des dekomprimierten Datensatzes externe Funktions- oder Baugruppen steuert.

9. Verfahren nach einem der Ansprüche 1 bis 8, wobei die Variablenwerte von einem komprimierenden oder dekomprimierenden String-Automaten wenigstens zum Teil geändert kodiert ausgegeben, oder erkannt und umgewandelt werden.

10. Verfahren nach einem der Ansprüche 1 bis 9, wobei zusätzliche Codierungsregeln zu Zustandsübergängen des String-Automaten gespeichert sind.

11. Verfahren nach einem der Ansprüche 1 bis 10, wobei Bitrepräsentationen der Steuersymbole zur Codierung von Zustandsübergängen unter Berücksichtigung von sich dynamisch ändernden Speicherinhalten berechnet werden.

12. Kompressionsvorrichtung zur Kompression eines Datensatzes, umfassend:
eine Hardware-Schaltung, die einen die vorab bekannten Strukturierungsregeln des Datensatzes repräsentierenden String-Automaten implementiert,
wobei die den String-Automaten implementierende Hardware-Schaltung angepasst ist, einen eingegebenen Datensatz, der Strukturbezeichner und Variablenwerte enthält, und der den vorab bekannten Strukturierungsregeln entspricht, zu verarbeiten, um einen komprimierten Datensatz zu erzeugen, wobei der komprimierte Datensatz den durch die Strukturbezeichner des eingegebenen Datensatzes bedingten Durchlauf durch den String-Automaten beschreibt, und
die den String-Automaten implementierende Hardware-Schaltung angepasst ist, neben den Variablenwerten des in den String-Automaten eingegebenen Datensatzes weiter Steuersymbole in den komprimierten Datensatz einzufügen, die die Zustandsübergänge des Durchlaufs des String-Automaten repräsentieren.

13. Dekompressionsvorrichtung zur Dekompression eines komprimierten Datensatzes, umfassend:
eine Hardware-Schaltung, die einen die vorab bekannten Strukturierungsregeln des Datensatzes repräsentierenden String-Automaten implementiert,
wobei die den String-Automaten implementierende Hardware-Schaltung angepasst ist, einen eingegebenen komprimierten Datensatz, der Steuersymbole und Variablenwerte enthält, und der den vorab bekannten Strukturierungsregeln entspricht, zu verarbeiten, um einen dekomprimierten Datensatz auszugeben, wobei der komprimierte Datensatz den Durchlauf durch den String-Automaten beschreibt, und
die den String-Automaten implementierende Hardware-Schaltung ferner angepasst ist, die Steuersymbole durch Strukturbezeichner zu ersetzen um dadurch einen dekomprimierten Datensatz mit den Strukturbezeichnern und den Variablenwerten zu erzeugen.

14. Dekompressionsvorrichtung nach Anspruch 13, wobei die den String-Automaten implementierende Hardware-Schaltung angepasst ist während des Verarbeitens des komprimierten Datensatzes zusätzlich oder alternativ zur Ausgabe des dekomprimierten Datensatzes externe Funktions- oder Baugruppen zu steuern.

15. Vorrichtung nach einem der Ansprüche 12 bis 14, wobei die Hardware-Schaltung einen Kellerautomaten implementiert und die Kompressionsvorrichtung dazu ferner einen Kellerspeicher aufweist.

16. Chip mit einer Kompressionsvorrichtung nach Anspruch 12 und/oder einer Dekompressionsvorrichtung nach Anspruch 13 oder 14.

## Claims

1. A method for compressing a data record, comprising the following steps:
inputting the data record into a string automaton of a compression apparatus, wherein the string automaton represents structuring rules of the data record which are known in advance, and wherein the input data record includes structure tags and values and complies with the structuring rules; and
processing the input data record by the string automaton to generate a compressed data record, wherein the compressed data record describes the string automaton's flow path caused by the structure tags of the input data record by including control symbols in addition to the values of the data record input into the string automaton, the control symbols representing the state transitions of the flow path of the string automaton.

2. The method according to claim 1, wherein in the step of processing the input data record by the string automaton, control symbols are inserted into the compressed data set only for automaton states having multiple possible subsequent states.

3. The method according to claim 1 or 2, further comprising the step of transmitting the compressed data record to a decompressing apparatus.

4. The method according to any one of claims 1 to 3, wherein the input data record is an XML document.

5. The method according to any one of claims 1 to 4, wherein the processing of the data record by the string automaton is controlled by external functional groups or modules.

6. The method according to any one of claims 1 to 5, further comprising the step of considering probabilities or frequencies of state transitions to find particularly suitable bit representations for the respective control symbols.

7. A method for decompressing a compressed data record, comprising the following steps:
inputting the compressed data record into a string automaton of a decompressing apparatus, wherein the string automaton represents structuring rules of the data record to be decompressed, the structuring rules being known in advance, and wherein the data record includes control symbols for the string automaton and values, and complies with the structuring rules; and
processing the input compressed data record by the string automaton to generate a decompressed data record, wherein the string automaton replaces the control symbols with structure tags to thereby generate the decompressed data record including the structure tags and the values.

8. The method according to claim 7, wherein the string automaton, while processing the compressed data record, controls external functional groups or modules in addition or alternatively to outputting the decompressed data record.

9. The method according to any one of claims 1 to 8, wherein the values are output with an at least partially altered encoding, or are recognized and converted, by a compressing or decompressing string automaton.

10. The method according to any one of claims 1 to 9, wherein additional encoding rules for state transitions of the string automaton are stored.

11. The method according to any one of claims 1 to 10, wherein bit representations of the control symbols for encoding state transitions are computed based on dynamically changing memory content.

12. A compression apparatus for compressing a data record, comprising:
a hardware circuit implementing a string automaton representing structuring rules of the data record which are known in advance,
wherein
the hardware circuit implementing the string automaton is adapted to process an input data record including structure tags and values which comply with the structuring rules, to generate a compressed data record, the compressed data record describing the the string automaton's flow path which is caused by the structure tags of the input data record, and
the hardware circuit implementing the string automaton is adapted to insert, in addition to the values of the data record input into the string automaton, control symbols into the compressed data record which represent the state transitions of the flow path of the string automaton.

13. A decompressing apparatus for decompressing a compressed data record, comprising:
a hardware circuit implementing a string automaton representing structuring rules of the data record which are known in advance,
wherein
the hardware circuit implementing the string automaton is adapted to process an input compressed data record including control symbols and values, and comprising with the structuring rules , for outputting a decompressed data record, the compressed data record describing the flow path of the string automaton, and
the hardware circuit implementing the string automaton is adapted to replace the control symbols with structure tags to thereby generate a decompressed data set including the structure tags and the values.

14. The decompressing apparatus according to claim 13, wherein the hardware circuit implementing the string automaton is adapted to control external functional groups or modules in addition or alternatively to outputting the decompressed data record, while processing the decompressed data record.

15. The apparatus according to any one of claims 12 to 14, wherein the hardware circuit implements a pushdown automaton and the compression apparatus further comprises a pushdown stack.

16. A chip including a compression apparatus according to claim 12 and/or a decompression apparatus according to claim 13 or 14.

## Revendications

1. Procédé de compression d'un enregistrement, comportant les étapes suivantes :
- la saisie de l'enregistrement dans l'automate de chaîne, sachant que l'automate de chaîne représente les règles de structuration préalablement connues de l'enregistrement d'un système de compression et sachant que l'enregistrement saisi contient des identificateurs de structure et des valeurs de variables et correspond aux règles de structuration préalablement connues,
- le traitement de l'enregistrement saisi au moyen de l'automate de chaîne pour produire un enregistrement comprimé, sachant que l'enregistrement comprimé décrit le passage par l'automate de chaîne déterminé par les identificateurs de structure de l'enregistrement saisi, en ceci qu'il contient, en plus des valeurs de variables de l'enregistrement saisi dans l'automate de chaîne, des symboles de commande qui représentent les transitions d'état du passage par l'automate de chaîne.

2. Procédé selon la revendication 1, dans lequel, lors du traitement de l'enregistrement saisi au moyen de l'automate de chaîne, seuls les symboles de commande pour les états d'automate qui possèdent plusieurs états séquentiels possibles, sont ajoutés à l'enregistrement comprimé.

3. Procédé selon la revendication 1 ou 2, comportant en outre l'étape de transmission de l'enregistrement comprimé à un dispositif de décompression.

4. Procédé selon l'une quelconque des revendications 1 à 3, dans lequel l'enregistrement saisi est un document XML.

5. Procédé selon l'une quelconque des revendications 1 à 4, dans lequel le traitement de l'enregistrement au moyen de l'automate de chaîne est commandé par des groupes de fonction ou de blocs externes.

6. Procédé selon l'une quelconque des revendications 1 à 5, comportant en outre l'étape consistant à prendre en compte les probabilités ou les occurrences de transitions d'état pour trouver des représentations de bits particulièrement adéquates pour les symboles de commande relatifs.

7. Procédé de décompression d'un enregistrement comprimé, comportant les étapes suivantes :
- la saisie de l'enregistrement comprimé dans l'automate de chaîne, sachant que l'automate de chaîne représente les règles de structuration préalablement connues de l'enregistrement à décomprimer d'un système de décompression et sachant que l'enregistrement contient des symboles de commande pour l'automate de chaîne et des valeurs de variables et correspond aux règles de structuration préalablement connues et
- le traitement de l'enregistrement saisi, comprimé, au moyen de l'automate de chaîne pour produire un enregistrement décomprimé, sachant que l'automate de chaîne remplace les symboles de commande par des identificateurs de structure pour produire ainsi l'enregistrement décomprimé avec les identificateurs de structure et les valeurs de variables.

8. Procédé selon la revendication 7, dans lequel l'automate de chaîne commande des groupes de fonction ou des blocs, pendant le traitement de l'enregistrement comprimé, en plus ou à la place de l'émission de l'enregistrement décomprimé.

9. Procédé selon l'une quelconque des revendications 1 à 8, dans lequel les valeurs de variables sont émises au moins en partie avec un code modifié ou détectées et converties par un automate de chaîne à compression ou décompression.

10. Procédé selon l'une quelconque des revendications 1 à 9, dans lequel des règles de codage supplémentaires sont enregistrées à des transitions d'état de l'automate de chaîne.

11. Procédé selon l'une quelconque des revendications 1 à 10, dans lequel les représentations de bits des symboles de commande sont calculées pour le codage de transitions d'état en tenant compte de contenus stockés dynamiquement variables.

12. Dispositif de compression pour la compression d'un enregistrement comportant :
- un circuit matériel qui met en oeuvre un automate de chaîne représentant les règles de structuration préalablement connues de l'enregistrement, sachant que le circuit matériel mettant en oeuvre l'automate de chaîne est conçu pour traiter un enregistrement saisi qui contient des identificateurs de structure et des valeurs de variables et qui correspond aux règles de structuration préalablement connues pour produire un enregistrement comprimé, sachant que l'enregistrement comprimé décrit le passage par l'automate de chaîne déterminé par les indicateurs de structure de l'enregistrement saisi et le circuit matériel mettant en oeuvre l'automate de chaîne est conçu pour ajouter, en plus des valeurs de variables de l'enregistrement saisi dans l'automate de chaîne, d'autres symboles de commande dans l'enregistrement comprimé, symboles qui représentent les transitions d'état du passage par l'automate de chaîne.

13. Dispositif de décompression pour la décompression d'un enregistrement comprimé, comportant :
- un circuit matériel qui met en oeuvre un automate de chaîne représentant les règles de structuration préalablement connues de l'enregistrement, sachant que le circuit matériel mettant en oeuvre l'automate de chaîne est conçu pour traiter un enregistrement comprimé saisi qui contient des symboles de commande et des valeurs de variables et qui correspond aux règles de structuration préalablement connues, pour donner un enregistrement décomprimé, sachant que l'enregistrement décomprimé décrit le passage par l'automate de chaîne et que le circuit matériel mettant en oeuvre l'automate de chaîne est conçu pour remplacer les symboles de commande par des identificateurs de structure pour produire ainsi un enregistrement décomprimé avec les identificateurs de structure et les valeurs de variables.

14. Dispositif de décompression selon la revendication 13, dans lequel le circuit matériel mettant en oeuvre l'automate de chaîne est conçu pour commander des groupes de fonction ou des blocs pendant le traitement de l'enregistrement comprimé, en plus ou à la place de la production de l'enregistrement décomprimé.

15. Dispositif selon l'une quelconque des revendications 12 à 14, sachant que le circuit matériel met en oeuvre un automate inversé et que le dispositif de compression comporte en plus de cela une mémoire à liste inversée.

16. Puce équipée d'un dispositif de compression selon la revendication 12 et/ou d'un dispositif de décompression selon la revendication 13 ou 14.
